# EUROPEAN PATENT APPLICATION

(11) **EP 4 646 064 A1**
(43) Date of publication of application: **05.11.2025**
(21) Application number: 24884187.6
(22) Date of filing: 27.08.2024
(51) Int. Cl.: H10F 19/90, H10F 77/20

(54) **BATTERY CELL, SOLAR CELL, AND PHOTOVOLTAIC MODULE**

(30) Priority: 03.11.2023 CN 202311466734
(71) Applicant: Tongwei Solar (Chengdu) Co., Ltd., Chengdu, Sichuan 610299 (CN)
(72) Inventor: WANG, Tianqi, Chengdu, Sichuan 610299 (CN); XING, Guoqiang, Chengdu, Sichuan 610299 (CN); XIA, Zhengyue, Chengdu, Sichuan 610299 (CN); SHEN, Haiping, Chengdu, Sichuan 610299 (CN)
(74) Representative: Gill Jennings & Every LLP
(86) International application number: PCT/CN2024/114769
(87) International publication number: WO 2025/092180

(57) **Abstract**

A battery cell, a solar cell, and a photovoltaic module. The front surface of the battery cell is provided with a plurality of front surface connecting stations distributed at intervals in a first direction, each front surface connecting station is provided with a plurality of first connecting parts distributed at intervals in a second direction, the back surface of the battery cell is provided with a plurality of back surface connecting stations distributed at intervals in the first direction, each back surface connecting station is provided with a plurality of second connecting parts distributed at intervals in the second direction, the plurality of first connecting parts of every two adjacent front surface connecting stations are distributed in a staggered manner, and/or the plurality of second connecting parts of every two adjacent back surface connecting stations are distributed in a staggered manner. The battery can reduce the reliability failure risk of the photovoltaic module.

## Description

### CROSS-REFERENCE TO RELATED APPLICATIONS

This application claims priority to Chinese Patent Application No. 2023114667344, entitled "BATTERY CELL, SOLAR CELL, AND PHOTOVOLTAIC MODULE", filed on November 3, 2023, the content of which is incorporated herein by reference in its entirety.

### TECHNICAL FIELD

The present disclosure relates to the field of photovoltaic technology, and in particular to a cell sheet, a solar cell, and a photovoltaic module.

### BACKGROUND

In the photovoltaic field, when preparing solar cells such as busbar-free cells or fine busbar cells, glue is printed on the cell sheet, and metal interconnection strips and cell sheets are tightly pressed through a pressing process. After the glue is cured, the metal interconnection strips and the cell sheets are bonded together. In traditional processes, glue spots are usually printed in a flush array. The positions of the glue spots printed on each busbar on the cell sheet are the same, and the positions of the glue spots on the front and back sides correspond. Then the metal interconnection strips are placed on the glue spots, and then a pressure needle or a pressure plate is used to press and cure the glue spots. Since the positions of the glue spots on the front and back sides of the cell sheet correspond, it is prone to cause hidden cracks in the cell sheet during curing and pressing. In addition, due to different heights of the glue spots and uneven down force during pressing, a part of fingers on the cell sheet cannot effectively contact the metal interconnection strips, which easily leads to loose connection and thus shadow problems in EL test. The shadow in EL test usually appears with a width of 2-3 fingers, which affects the power of the photovoltaic module, has the risk of reliability failure and is prone to hidden cracks.

### SUMMARY

Accordingly, it is necessary to provide a cell sheet. The cell sheet of the present disclosure can effectively optimize the loose connection problem, reduce the power reduction caused by loose connection, reduce the risk of reliability failure of photovoltaic modules, and effectively control the hidden crack problem of cell sheets, reduce the loss of cell sheets, and reduce the degradation rate of photovoltaic modules.

A cell sheet is provided according to an embodiment of the present disclosure.

A front side of the cell sheet is provided with a plurality of front connection stations spaced apart along a first direction formed from one side of the cell sheet to another side opposite thereto, and each front connection station has a plurality of first connection portions spaced apart along a second direction. A back side of the cell sheet is provided with a plurality of back connection stations spaced apart along the first direction, and each back connection station has a plurality of second connection portions spaced apart along the second direction.

The plurality of first connection portions of adjacent two front connection stations are staggered; and/or the plurality of second connection portions of adjacent two back connection stations are staggered.

**In** some embodiments, the second direction is an extension direction of a metal interconnection strip, and the first direction is perpendicular to the second direction.

In some embodiments, the plurality of the front connection stations and the plurality of the back connection stations are in a one-to-one correspondence along the first direction. The plurality of the first connection portions constitute a first connection member, the plurality of the second connection portions constitute a second connection member, and at least one group of corresponding first connection member on the front connection station and the second connection member on the back connection station are staggered along the second direction in a thickness direction of the cell sheet.

In some embodiments, the first connection portion is formed by printing, coating, or dispensing.

In some embodiments, the second connection portion is formed by printing, coating, or dispensing.

In some embodiments, the plurality of first connection portions are in a dot shape, a segment shape, or a combination shape of dot and segment.

In some embodiments, the plurality of second connection portions are in a dot shape, a segment shape, or a combination shape of dot and segment.

In some embodiments, spacings between adjacent two front connection stations are equal.

In some embodiments, spacings between adjacent two back connection stations are equal.

In some embodiments, spacings between adjacent two front connection stations are equal to spacings between adjacent two back connection stations.

In some embodiments, spacings between adjacent two first connection portions on the front connection station are equal.

In some embodiments, spacings between adjacent two second connection portions on the back connection station are equal.

In some embodiments, spacings between adjacent two first connection portions are equal to spacings between adjacent two second connection portions.

A solar cell is further provided according to an embodiment of the present disclosure.

The solar cell includes metal interconnection strips, adhesive members, and a plurality of cell sheets. The plurality of cell sheets are sequentially distributed. Adjacent two cell sheets are connected by a plurality of metal interconnection strips. The adhesive members are provided on the plurality of the first connection portions on the plurality of front connection stations on the plurality of cell sheets. The adhesive members are provided on the plurality of the second connection portions on the plurality of back connection stations on the plurality of cell sheets. A part of the metal interconnection strips are connected to the adhesive members on the front connection station of one of the adjacent two cell sheets, and another part of the metal interconnection strips are connected to the adhesive members on the back connection station of another of the adjacent two cell sheets.

A photovoltaic module is further provided according to an embodiment of the present disclosure.

The photovoltaic module includes the solar cell.

The aforementioned cell sheet can effectively optimize the virtual connection problem, reduce the power reduction caused by virtual connection, reduce the risk of reliability failure of photovoltaic modules, and effectively control the hidden crack problem of cell sheets, reduce the loss of cell sheets, and reduce the degradation rate of photovoltaic modules. Specifically, in the present disclosure, by changing the position of glue spots on adjacent busbars and printing glue spots on the front and back sides of the cell sheet in a staggered manner, shadows in EL test are reduced, abnormal power of photovoltaic modules are avoided, and the reliability of photovoltaic modules is improved. By changing the position of glue spots on the front and back sides of the cell sheet, an effective combination of metal interconnection strips and glue spots can be achieved, virtual connections can be avoided, which improves the problem of hidden cracks in the cell sheet during the manufacturing process, and reduces the degradation rate of photovoltaic modules.

### BRIEF DESCRIPTION OF THE DRAWINGS

To illustrate the technical solutions according to the embodiments of the present disclosure more clearly, the accompanying drawings for describing the embodiments are introduced briefly in the following. Apparently, the accompanying drawings in the following description are only some embodiments of the present disclosure, and persons of ordinary skill in the art can derive other drawings from the accompanying drawings without creative efforts.

In order to more completely understand the present disclosure and its beneficial effects, the following description will be given in conjunction with the accompanying drawings. In the following description, same reference numerals denote the same parts.
FIG. 1 is a schematic view of a cell sheet according to an embodiment of the present disclosure.
FIG. 2 is a schematic side view of a cell sheet according to an embodiment of the present disclosure.
FIG. 3 is a schematic view of a partial structure of the cell sheet shown in FIG. 1.

### Reference Numerals:

10, cell sheet; 100, front connection station; 101, first connection portion; 200, back connection station; 201, second connection portion.

### DETAILED DESCRIPTION

In order to make the above objectives, features and advantages of the present disclosure more obvious and understandable, specific embodiments of the present disclosure are described in detail below with reference to the accompanying drawings. In the following description, many specific details are set forth in order to fully understand the present disclosure. However, the present disclosure can be implemented in many other ways different from those described herein, and those skilled in the art can make similar improvements without departing from the connotation of the present disclosure. Therefore, the present disclosure is not limited by the specific embodiments disclosed below.

In the description of the present disclosure, it should be understood that terms "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", "radial", "circumferential", etc. indicate an orientation or a positional relationship based on an orientation or a positional relationship shown in the drawings, which is only for the purpose of facilitating and simplifying the description of the present disclosure, rather than indicates or implies that the device or elements must have a specific orientation, be constructed and operated in a specific orientation, and therefore cannot be construed as limitation of the present disclosure.

In the present disclosure, the terms "mounting," "connecting together," "connecting," "fixing" and the like should be understood broadly. For example, it could be understood as a fixed connection, a detachable connection, or an integrated connection; it could be understood as a mechanical connection or an electrical connection; it could be understood as a direct connection or an indirect connection by an intermediate medium; and it could be understood as an internal communication between two elements or an interaction between two elements, unless otherwise expressly defined. For those who skill in the art, the specific meaning of the aforementioned terms in the present disclosure can be understood according to specific situations.

In the present disclosure, unless expressly stipulated and defined otherwise, the first feature "on" or "under" the second feature may refer to that the first and second features are in direct contact, or the first and second features are in indirectly contact through an intermediary. Furthermore, the first feature being "above", "over", or "on" the second feature may refer to that the first feature is directly above or obliquely above the second feature, or refer to that the height of the first feature is greater than the height of the second feature. The first feature being "below", "underneath" or "under" the second feature may refer to that the first feature is directly below or obliquely below the second feature, or refer to that the height of the first feature is less than the second feature.

In the description of the present disclosure, "several" means more than one, "multiple" means more than two, "greater than", "less than", "exceed", etc. are understood to exclude the number, and "above", "below", "within", etc. are understood to include the number. If the first and second are described, they are only used to distinguish the technical features and cannot be understood as indicating or implying relative importance or implicitly indicating the number of the indicated technical features or implicitly indicating the sequence of the indicated technical features.

All technical and scientific terms used herein have the same meaning as commonly understood by those of ordinary skill in the art to which the present disclosure applies, unless otherwise defined. The terms used in the specification of the present disclosure herein are for the purpose of describing specific embodiments only and are not intended to limit the present disclosure. The term "and/or" used herein includes any and all combinations of one or more of the associated listed items.

A cell sheet 10 is provided according to an embodiment of the present disclosure, so as to solve following problems in the prior art: the same printing position of glue spots on the front and back sides of the cell sheet 10 is prone to cause hidden cracks in the cell sheet 10 during curing and pressing; and due to different heights of the glue spots and uneven down force during pressing, a part of fingers on the cell sheet 10 cannot effectively contact the metal interconnection strips, which easily leads to cause loose connection and thus shadow problems in EL test, affecting the power of the photovoltaic module and bringing the risk of reliability failure The cell sheet 10 will be described below with reference to the accompanying drawings.

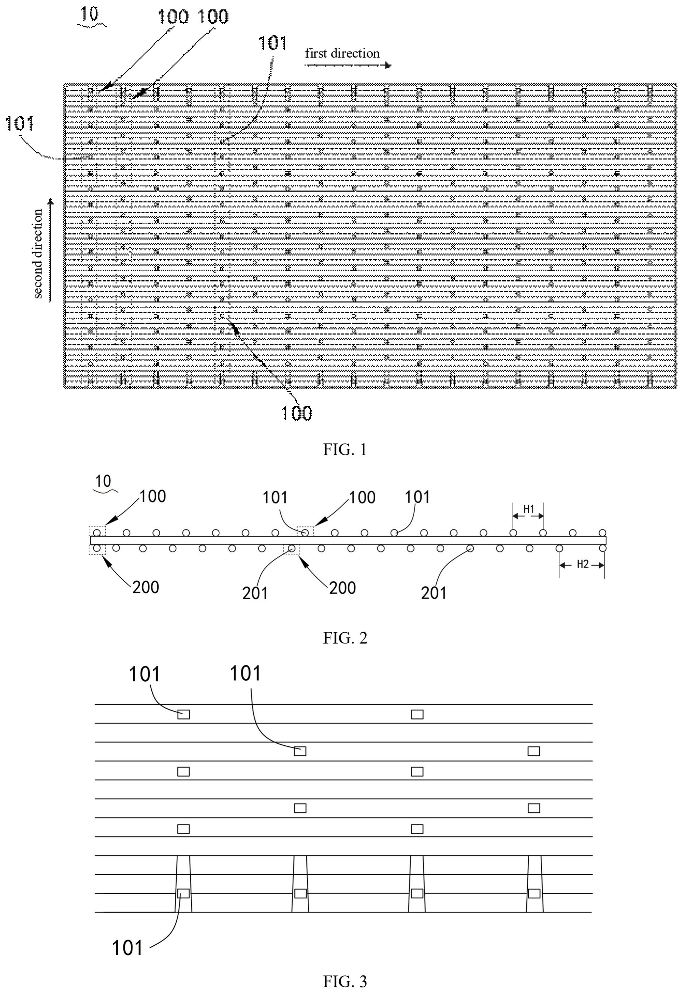

The cell sheet 10 provided according to the embodiments of the present disclosure is exemplified as shown in FIG. 1, which is a schematic view of the cell sheet 10 provided according to embodiments of the present disclosure. The cell sheet 10 according to the present disclosure can be used for the production and preparation of solar cells in the photovoltaic field.

In order to more clearly illustrate the structure of the cell sheet 10, the cell sheet 10 will be introduced below with reference to the accompanying drawings.

For example, referring to FIG. 1, a cell sheet 10 is shown. A front side of the cell sheet 10 is provided with a plurality of front connection stations 100. The front connection stations 100 are shown in the dotted box areas in FIGS. 1 and 2, and only a part of the front connection stations 100 is shown in FIGS. 1 and 2. The plurality of front connection stations 100 are spaced apart along a first direction formed from one side of the cell sheet 10 to another side opposite thereto. Each front connection station 100 has a plurality of first connection portions 101 spaced apart along a second direction.

A back side of the cell sheet 10 is provided with a plurality of back connection stations 200. The back side connection stations 200 are shown in the dotted line box in FIG. 2, and only a part of the back side connection stations 200 is shown in FIG. 2. The plurality of back connection stations 200 are spaced apart along the first direction. Each back connection station 200 has a plurality of second connection portions 201 spaced apart along the second direction.

The plurality of first connection portions 101 of adjacent two front connection stations 100 are staggered. The plurality of second connection portions 201 of adjacent two back connection stations 200 are staggered.

The aforementioned cell sheet 10 can effectively optimize the loose connection problem, reduce the power reduction caused by loose connection, reduce the risk of reliability failure of photovoltaic modules, and effectively control the hidden crack problem of the cell sheet 10, reduce the loss of the cell sheet 10, and reduce the degradation rate of photovoltaic modules.

In some embodiments, the second direction is an extension direction of a metal interconnection strip, and the first direction is perpendicular to the second direction. For example, as shown in FIG. 1, the first direction may be a length direction of the cell sheet 10, and the second direction may be a width direction of the cell sheet 10.

In some embodiments, as shown in FIG. 2, the plurality of the front connection stations 100 and the plurality of the back connection stations 200 are in a one-to-one correspondence along the first direction. The plurality of the first connection portions 101 constitute a first connection member, the plurality of the second connection portions 201 constitute a second connection member, and at least one group of corresponding first connection member on the front connection station 100 and the second connection member on the back connection station 200 are staggered along the second direction in a thickness direction of the cell sheet 10. Preferably, the first connection member on the front connection stations 100 and the second connection member on the back connection stations 200 in each group are staggered along the second direction in the thickness direction of the cell sheet 10.

In some embodiments, the first connection portion 101 is formed by printing, coating, or dispensing.

In some embodiments, the second connection portion 201 is formed by printing, coating, or dispensing.

In some embodiments, the number of the front connection stations 100 is plural, for example, the number of the front connection stations 100 is two, three, four, five, etc. The number of the front connection stations 100 can be set according to the size of the cell sheet 10.

In some embodiments, the number of the front connection stations 100 is equal to the number of the back connection stations 200. The number of the back connection stations 200 and the number of the front connection stations 100 may be adapted to achieve a one-to-one correspondence.

In some embodiments, the number of the first connection portions 101 on the front connection station 100 is plural, for example, the number of the first connection portions 101 on the front connection station 100 is two, three, four, five, etc.

In some embodiments, the number of the second connection portions 201 on the back connection station 200 is plural, for example, the number of the second connection portions 201 on the back connection station 200 is two, three, four, five, etc.

In some embodiments, as shown in FIG. 2, along the first direction, the first front connection station 100 is aligned with the first back connection station 200, and the last front connection station 100 is aligned with the last back connection station 200.

In some embodiments, as shown in FIG. 2, along the first direction, the other front connection stations 100 between the first front connection station 100 and the last front connection station 100, and the other back connection stations 200 between the first back connection station 200 and the last back connection station 200 are staggered.

For example, in a specific embodiment, referring to FIG. 2, the number of the front connection stations 100 and the number of the back connection stations 200 are eighteen, respectively. The first front connection station 100 is aligned with the first back connection station 200, and the eighteenth front connection station 100 is aligned with the eighteenth back connection station 200. The second to seventeenth front connection stations 100 and the second to seventeenth back connection stations 200 are staggered, respectively.

In some embodiments, as shown in FIG. 2, spacings between adjacent two front connection stations 100 are equal. The spacings between adjacent two front connection stations 100 can be set according to actual needs.

In some embodiments, as shown in FIG. 2, spacings between adjacent two back connection stations 200 are equal. The spacings between adjacent two back connection stations 200 can be set according to actual needs.

In some embodiments, spacings between adjacent two front connection stations 100 are equal to spacings between adjacent two back connection stations 200. Such an arrangement facilitates the design of distribution of pressing plates and pressing needles in the printing and pressing processes.

For example, in a specific embodiment, referring to FIG. 2, the number of the front connection stations 100 and the number of the back connection stations 200 are eighteen, respectively. The first front connection station 100 is aligned with the first back connection station 200, and the eighteenth front connection station 100 is aligned with the eighteenth back connection station 200. The second to seventeenth front connection stations 100 and the second to seventeenth back connection stations 200 are staggered, respectively. Spacings between adjacent two front connection stations 100 are equal, and spacings between adjacent two back connection stations 200 are equal. Since the second to the seventeenth front connection stations 100 and the second to the seventeenth back connection stations 200 are staggered, the spacing H1 between adjacent two front connection stations 100 and the spacing H1 between adjacent two back connection stations 200 are equal, but the spacing H2 between the sixteenth and seventeenth back connection stations 200 is different, as shown in FIG. 2, the spacing H2 between the sixteenth and seventeenth back connection stations 200 is used as staggered compensation.

In some embodiments, the plurality of first connection portions 101 may be in a dot shape, a segment shape, or a combination shape of dot and segment. When it is in a combination shape of dot and segment, the specific combination form can be set as needed. When the first connection portion 101 is in a segment shape, its length can be set as needed.

In some embodiments, the second connection portion 201 may be in a dot shape, a segment shape, or a combination shape of dot and segment. When it is in a combination shape of dot and segment, the specific combination form can be set as needed. When the second connection portion 201 is in a segment shape, its length can be set as needed.

Referring to FIG. 1, the first connection portion 101 shown in FIG. 1 is in a dot shape. Preferably, the second connection portion 201 is in a dot shape.

In some embodiments, referring to FIGS. 1 and 3, spacings between adjacent two first connection portions 101 on the front connection station 100 are equal.

In some embodiments, spacings between adjacent two second connection portions 201 on the back connection station 200 are equal.

In some embodiments, spacings between adjacent two first connection portions 101 are equal to spacings between adjacent two second connection portions 201.

In some embodiments, the height of the first connection portion 101 can be set according to actual needs. For example, the height of the first connection portion 101 ranges from 0.1 mm to 10 mm.

In some embodiments, the height of the second connection portion 201 can be set according to actual needs. For example, the height of the second connection portion 201 ranges from 0.1 mm to 10 mm.

In some embodiments, when spacings between adjacent two first connection portions 101 on each front connection station 100 are equal, the spacing in the second direction between the first connection portion 101 on one of the adjacent two front connection stations 100 and the staggered first connection portions 101 on the adjacent two front connection stations 100 is equal to half of the spacing between the adjacent two first connection portions 101. It can be understood that in other embodiments, the staggered spacings of the plurality of first connection portions 101 of adjacent two front connection stations 100 can be set as needed.

A solar cell is further provided according to an embodiment of the present disclosure.

The solar cell includes metal interconnection strips, adhesive members, and a plurality of cell sheets 10. The plurality of cell sheets 10 are sequentially distributed. Adjacent two cell sheets 10 are connected by a plurality of metal interconnection strips. The adhesive members are provided on the plurality of the first connection portions 101 on the plurality of front connection stations 100 on the plurality of cell sheets 10. The adhesive members are provided on the plurality of the second connection portions 201 on the plurality of back connection stations 200 on the plurality of cell sheets 10. A part of the metal interconnection strips are connected to the adhesive members on the front connection station 100 of one of the adjacent two cell sheets 10. Another part of the metal interconnection strips are connected to the adhesive members on the back connection station 200 of another of the adjacent two cell sheets 10.

In some embodiments, when the aforementioned solar cell is a busbar-free cell or a fine busbar cell, the metal interconnection strips are electrically connected to the fine busbars on the front or back side of the cell sheet 10.

In some embodiments, the solar cell further includes a front panel, a front adhesive film, a back panel, and a back adhesive film. The front panel, the front adhesive film, the back panel, and the back adhesive film are sequentially stacked, and a plurality of cell sheets 10 are stacked between the front adhesive film and the back adhesive film. The front panel may be a front glass panel. The back panel may be a back glass panel.

In some embodiments, the adhesive member may be in the form of glue spots, tape, or other forms.

A photovoltaic module is further provided according to an embodiment of the present disclosure.

The photovoltaic module includes a solar cell.

In some embodiments, the photovoltaic module further includes an encapsulation frame. The solar cell is encapsulated by the encapsulation frame. The number of the encapsulation frame may be one or more. The length of the encapsulation frame can be set according to actual needs.

In sum, in the present disclosure, by changing the position of glue spots on adjacent busbars and printing glue spots on the front and back sides of the cell sheet 10 in a staggered manner, shadows in EL test are reduced, abnormal power of photovoltaic modules are avoided, and the reliability of photovoltaic modules is improved. By changing the position of glue spots on the front and back sides of the cell sheet 10, an effective combination of metal interconnection strips and glue spots can be achieved, virtual connections can be avoided, which improves the problem of hidden cracks in the cell sheet 10 during the manufacturing process, and reduces the degradation rate of photovoltaic modules.

In the above embodiments, description of each embodiment has its own emphasis. For a part that is not described in detail in an embodiment, related descriptions in other embodiments can be referred.

Each of the technical features of the aforementioned embodiments can be combined arbitrarily. To simplify the description, not all the possible combinations of the technical features in the aforementioned embodiments are described. However, all of the combinations of these technical features should be considered as within the scope of the present disclosure, as long as such combinations do not contradict with each other.

The aforementioned embodiments merely illustrate several embodiments of the present disclosure, and the description thereof is specific and detailed, but it shall not be constructed as limiting the scope of the disclosure. It should be noted that a plurality of variations and modifications may be made by those skilled in the art without departing from the conception of the present disclosure, which are all within the protection scope of the present disclosure. Therefore, the protection scope of the present disclosure shall be subject to the appended claims.

## Claims

1. A cell sheet (10), wherein a front side of the cell sheet (10) is provided with a plurality of front connection stations (100) spaced apart along a first direction formed from one side of the cell sheet (10) to another side opposite thereto, each front connection station (100) has a plurality of first connection portions (101) spaced apart along a second direction;
wherein a back side of the cell sheet (10) is provided with a plurality of back connection stations (200) spaced apart along the first direction, and each back connection station (200) has a plurality of second connection portions (201) spaced apart along the second direction;
wherein the plurality of first connection portions (101) of adjacent two front connection stations (100) are staggered; and/or the plurality of second connection portions (201) of adjacent two back connection stations (200) are staggered.

2. The cell sheet (10) according to claim 1, wherein the second direction is an extension direction of a metal interconnection strip, and the first direction is perpendicular to the second direction.

3. The cell sheet (10) according to claim 1, wherein the plurality of the front connection stations (100) and the plurality of the back connection stations (200) are in a one-to-one correspondence along the first direction, the plurality of the first connection portions (101) constitute a first connection member, the plurality of the second connection portions (201) constitute a second connection member, and at least one group of corresponding first connection member on the front connection station (100) and the second connection member on the back connection station (200) are staggered along the second direction in a thickness direction of the cell sheet (10).

4. The cell sheet (10) according to claim 1, wherein the first connection portion (101) is formed by printing, coating, or dispensing.

5. The cell sheet (10) according to claim 1, wherein the second connection portion (201) is formed by printing, coating, or dispensing.

6. The cell sheet (10) according to claim 1, wherein the plurality of first connection portions (101) are in a dot shape, a segment shape, or a combination shape of dot and segment.

7. The cell sheet (10) according to claim 1, wherein the plurality of second connection portions (201) are in a dot shape, a segment shape, or a combination shape of dot and segment.

8. The cell sheet (10) according to any one of claims 1 to 7, wherein spacings between adjacent two front connection stations (100) are equal.

9. The cell sheet (10) according to any one of claims 1 to 7, wherein spacings between adjacent two back connection stations (200) are equal.

10. The cell sheet (10) according to any one of claims 1 to 7, wherein spacings between adjacent two front connection stations (100) are equal to spacings between adjacent two back connection stations (200).

11. The cell sheet (10) according to any one of claims 1 to 7, wherein spacings between adjacent two first connection portions (101) on the front connection station (100) are equal.

12. The cell sheet (10) according to any one of claims 1 to 7, wherein spacings between adjacent two second connection portions (201) on the back connection station (200) are equal.

13. The cell sheet (10) according to any one of claims 1 to 7, wherein spacings between adjacent two first connection portions (101) are equal to spacings between adjacent two second connection portions (201).

14. A solar cell, comprising metal interconnection strips, adhesive members, and a plurality of cell sheets (10) according to any one of claims 1 to 13, wherein the plurality of cell sheets (10) are sequentially distributed, adjacent two cell sheets (10) are connected by a plurality of metal interconnection strips, the adhesive members are provided on the plurality of the first connection portions (101) on the plurality of front connection stations (100) on the plurality of cell sheets (10), the adhesive members are provided on the plurality of the second connection portions (201) on the plurality of back connection stations (200) on the plurality of cell sheets (10), a part of the metal interconnection strips are connected to the adhesive members on the front connection station (100) of one of the adjacent two cell sheets (10), and another part of the metal interconnection strips are connected to the adhesive members on the back connection station (200) of another of the adjacent two cell sheets (10).

15. A photovoltaic module, comprising the solar cell according to claim 14.
